# EUROPEAN PATENT APPLICATION

(11) **EP 0 872 926 A1**
(43) Date of publication of application: **21.10.1998**
(21) Application number: 97943161.6
(22) Date of filing: 08.10.1997
(51) Int. Cl.: H01S 3/18

(54) **OPTICAL SEMICONDUCTOR MODULE**

(30) Priority: 09.10.1996 JP 268598/96
(71) Applicant: THE FURUKAWA ELECTRIC CO., LTD., Tokyo 100 (JP)
(72) Inventor: MORI, Hajime, Chiba 290 (JP); MUGINO, Akira, Ichihara-shi Chiba 290 (JP); SHIMIZU, Takeo, Fujisawa-shi Kanagawa 251 (JP)
(74) Representative: Modiano, Guido, Dr.-Ing.
(86) International application number: JP9703622
(87) International publication number: WO9815995

(57) **Abstract**

An optical semiconductor module which is constituted by mounting an optical semiconductor element forming a projecting section composed of an abnormally grown crystal on its surface on a substrate having a recessed section, which can house the projecting section of the semiconductor element in a non-contacting state on its surface by using the junction down system. Therefore, the mounted element is not damaged nor broken and the characteristics of the element are not deteriorated.

## Description

### TECHNICAL FIELD

The present invention relates to an optical semiconductor module in which an optical semiconductor device is mounted on a board for mounting the optical semiconductor device (hereinafter called a board) with the epi-side down system and, more particularly, to an optical semiconductor module in which damages and property deterioration of the mounted optical semiconductor device can be prevented.

### BACKGROUND ART

Various types of optical semiconductor devices are used in a modularized form by connecting an optical fiber or optical waveguide to the light incident/emissive end faces. In this case, the optical axes of the optical semiconductor device and the optical fiber or optical waveguide must be made to agree with each other.

In particular, when an optical fiber or the like is connected to a semiconductor laser device (LD) or waveguide type photodiode (WG-PD), the axis adjustment must be made so that the positional shift is controlled within an accuracy of about ±1 µm.

Conventionally, the aforesaid axis adjustment has been made as follows: For example, the LD is energized while the end face of optical fiber is in contact with the emissive end face of LD, the output light from the optical fiber is monitored, and the LD and optical fiber are connected and fixed to each other at a position where the light output is at a maximum assuming that the agreement of light axes is attained at this position.

However, the axis adjustment made by this method requires very troublesome work and has a limitation in enhancing the productivity for modularization.

In recent years, therefore, a method in which an optical semiconductor device is directly mounted on a board has been being studied. Specifically, in this method, a positioning marker is precisely scribed in advance on both of the optical semiconductor device to be mounted and the board, and both markers are made to agree with each other.

This case usually applies a so-called "epi-side down" mode of making an optical semiconductor device mounted with its top surface (downward) in contact with the mounting face of a board.

The reason for this is that the back surface of the optical semiconductor device has a surface roughness with an accuracy of about ±10 µm although being ground, whereas for the top surface thereof formed as a semiconductor laminated structure by the vapor phase epitaxial growth method, the thickness accuracy of each semiconductor layer is controlled to about ±0.1 µm, so that the top surface is superior to the back surface as the reference surface for determining the height of light receiving/emitting portion of the optical semiconductor device, and therefore the positioning accuracy in the height direction can be enhanced.

When the optical semiconductor device is manufactured by succeedingly stacking predetermined semiconductor layers on a semiconductor substrate by the vapor phase epitaxial growth method, a convex portion having a certain length, width, and height is sometimes produced at a part of the surface of the formed semiconductor laminated structure.

This phenomenon will be explained by taking the case of a laser diode with mode-field converter (MFC-LD) having a structure such that the mode field is widened to enhance the coupling efficiency with an optical fiber as an example.

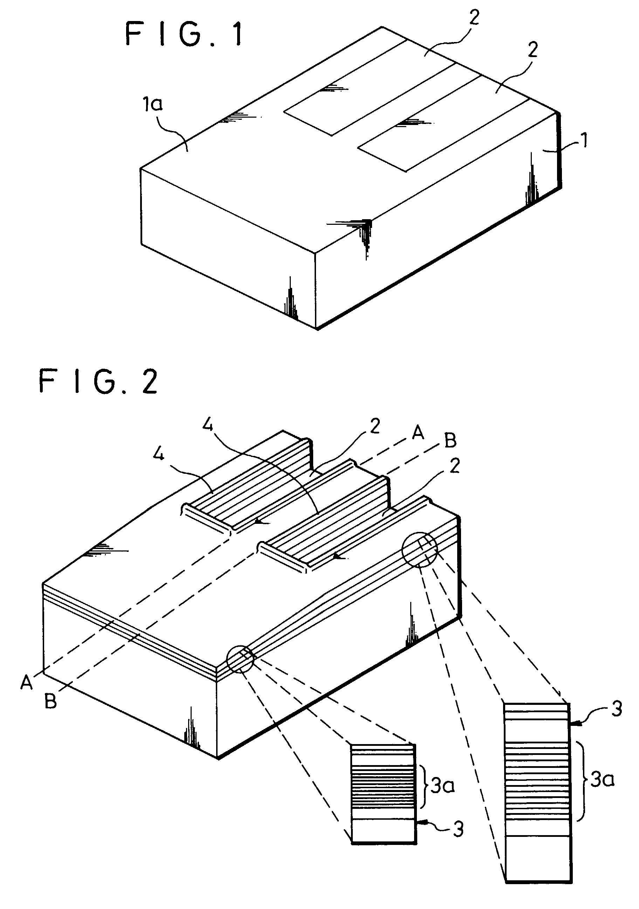

When this device is manufactured, as shown in FIG. 1, for example, SiNx is first patterned at predetermined locations on a surface 1a of a semiconductor substrate 1 to form SiNx zones 2, 2 of a desired pattern (rectangular pattern in FIG. 1).

Next, the vapor phase epitaxial growth method is applied to the surface 1a of the semiconductor substrate 1. By making semiconductors of a predetermined composition epitaxially grow succeedingly, a semiconductor laminated structure containing, for example, a quantum well structure is formed.

At this time, the epitaxial growth of semiconductor does not occur on the SiNx zones 2, 2, so that the semiconductor laminated structure is not formed on the SiNx zones.

The semiconductor laminated structure formed on the substrate 1 is usually constructed as described below.

First, on the substrate surface positioned in the vicinity of the SiNx zones 2, 2, a convex portion having a certain width and height is formed into a bank shape so as to surround the SiNx zone when the semiconductor crystals grow. In this case, the convex portion in the vicinity of the end in the lengthwise direction (in the vicinity of short side in the figure) of the SiNx zone 2, 2 has a considerably large shape, whereas the convex portions in the vicinity of both sides of the SiNx zone 2, 2 has a relatively small shape.

At both sides of the SiNx zone 2, 2, a laminated structure is formed such that the semiconductor layers with a great and uniform thickness are laminated and a tapered laminated structure is formed such that the thickness of the semiconductor layer decreases as the distance in the lengthwise direction from the SiNx zone 2, 2 increases.

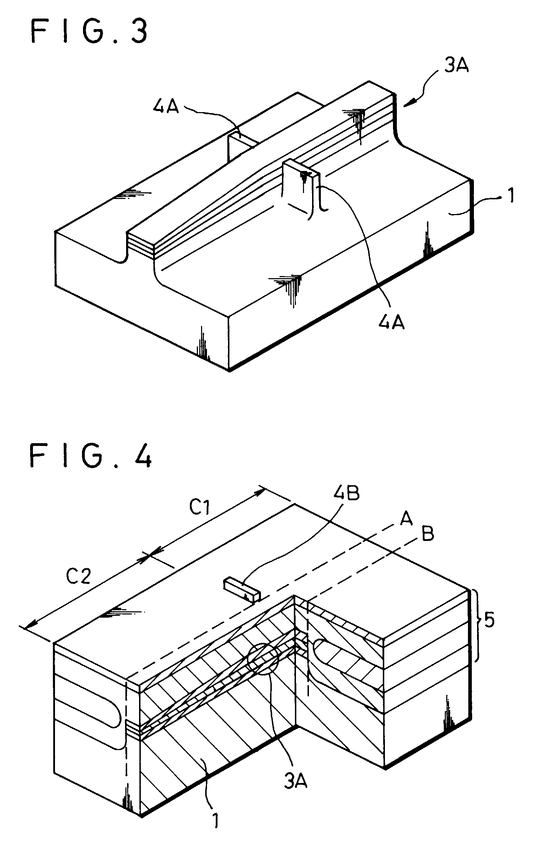

Therefore, at the time when the vapor phase epitaxial growth has been completed, as shown in FIG. 2, the laminated structure 3 formed on the semiconductor substrate 1 is depressed at the locations of the SiNx zones 2, 2, and has a surface state in which a quantum well structure 3a is contained and bank-shaped convex portions 4, 4 exist at the boundary positions of the SiNx zones 2, 2.

Then, the publicly known mesa etching is performed along the lines A-A and B-B in FIG. 2, by which the portions other than the portion held between the lines A-A and B-B are removed from the surface of the semiconductor substrate 1 down to a desired depth while the portion held between the lines A-A and B-B is left.

As a result, as shown in FIG. 3, a ridge-shaped waveguide 3A is formed on the semiconductor substrate 1.

In this process, the convex portions formed in the vicinity of both sides of the SiNx zone 2, 2 are removed by etching, but the convex portion formed in the vicinity of the short side of the SiNx zone 2, 2 remains substantially as it is without being completely removed by etching. Therefore, the aforesaid convex portion remains as wing-shaped protrusions 4A, 4A at the sides of the ridge-shaped waveguide 3A after mesa etching. No cause of that propensity has yet been made clear; but, it is conceivable that convex portions 4,4 grown in the borders of SiNx zones 2,2 would differ in etching sensitivity between the long and short sides. In brief, some variance of etching sensitivity could take place between the regions astride SiNx zones 2,2, and the borders of the short sides, because of a possible difference in composition or crystalline structure therebetween.

Needless to say, if the etching time is increased, these wing-shaped protrusions 4A, 4A can also be removed by etching. In this case, however, the width and height of the ridge-shaped waveguide 3A become smaller than the intended design reference values, which presents a problem of inducing property deterioration as an optical semiconductor device.

Therefore, usually the ridge-shaped waveguide 3A is embedded by using another semiconductor while the wing-shaped protrusions 4A, 4A exist as shown in FIG. 3, and the confining ability of injection current is given to the intended optical semiconductor device.

That is, by applying the vapor phase epitaxial growth method onto the device precursor shown in FIG. 3, a semiconductor laminated structure 5 is formed at both sides of and over the ridge-shaped waveguide 3A so that the ridge-shaped waveguide 3A is embedded as shown in FIG. 4.

At this time, the wing-shaped protrusions 4A, 4A shown in FIG. 3 are also embedded at the same time. In this case, semiconductors are stacked on the wing-shaped protrusions 4A, 4A as well, so that consequently the portions of the wing-shaped protrusions 4A, 4A are raised as convex portions 4B, 4B on the surface of the manufactured optical semiconductor device.

That is, the convex portions 4B, 4B, which are analogs of the wing-shaped protrusions 4A, 4A shown in FIG. 3, are formed on the surface of the manufactured mode field converting laser device.

For the laser device thus manufactured shown in FIG. 4, the portion having a constant thickness of each semiconductor layer in the ridge-shaped waveguide 3A, concretely, the portion indicated by C1 in FIG. 4 functions as an active section, whereas the portion having a tapered thickness of each semiconductor layer indicated by C2 functions as a mode field converting section. That is, when the light incident on the active section C1 is propagated through the active section C1 and enters the laminated structure having a tapered thickness, the light spreads in the longitudinal and transverse directions in the process in which the light is propagated through the laminated structure C2 because the laminated structure C2 has a small light confining effect, with the result that the mode field is widened.

However, if the laser device having the convex portions 4B, 4B formed on the top surface as shown in FIG. 4 is mounted on a board with the epi-side down system to make a module, the following problem arises.

That is, because the surface of the ordinary board is flat, the convex portions 4B, 4B of the laser device come into contact with the flat surface, so that a pressure is concentrated on the convex portions 4B, 4B, which causes the breakage of semiconductor laminated structure and the property deterioration of the device itself. Thereupon, the function of the obtained optical semiconductor module is decreased.

Such a problem can be solved by decreasing the height of the ridge-shaped waveguide 3A formed on the substrate, or by thinly applying a resist onto the portions other than the protruding convex portions at the aforesaid mesa etching time, and then by selectively dry etching the convex portions to remove the convex portions.

However, the former solution has a great influence on the property of the manufactured laser device, so that such a design change is actually difficult to make. Also, the latter solution makes the device manufacturing process complicated, so that it is undesirable from the industrial viewpoint.

An object of the present invention is to provide an optical semiconductor module configured by mounting an optical semiconductor device having convex portions on the surface thereof on a board, in which the breakage and property deterioration of the mounted optical semiconductor device are not caused.

### DISCLOSURE OF THE INVENTION

To achieve the above object, the present invention provides an optical semiconductor module comprising an optical semiconductor device on the surface of which a convex portion produced at the crystal growth time exists and a board on the surface of which a concave portion capable of accommodating the convex portion is formed, the optical semiconductor device being mounted on the board in a state in which the convex portion is accommodated in the concave portion.

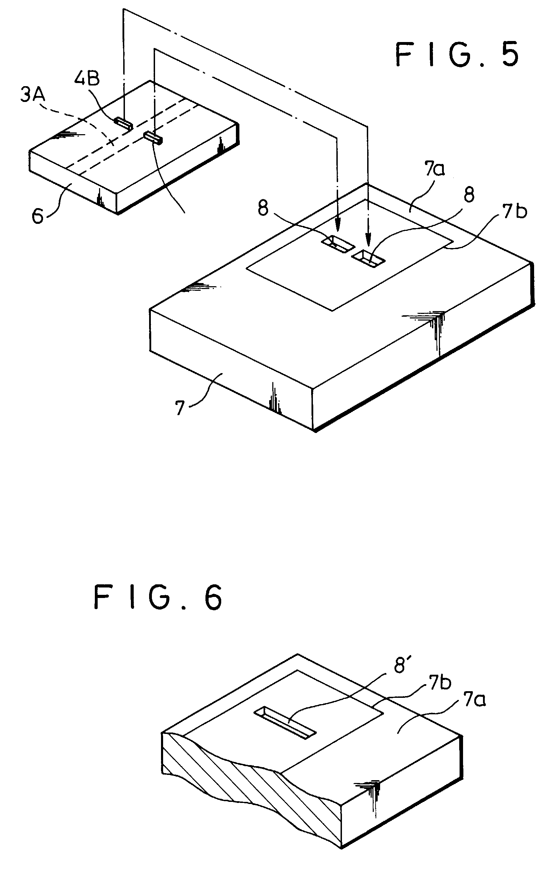

FIG. 5 is an exploded perspective view of an optical semiconductor module in accordance with the present invention. For this optical semiconductor module, an optical semiconductor device (MFC-LD) 6, for example, shown in FIG. 4 is mounted on a flat surface 7a of a board 7 with the epi-side down system.

On the surface 7a of the board 7, a marker 7 for positioning the optical semiconductor device 6 to be mounted is scribed, and two concave portions 8, 8 of a size and shape such as to accommodate two convex portions 4B, 4B formed on the surface of the semiconductor device 6 are formed.

The size and shape of the concave portion 8, 8 may be such that the convex portion 4B, 4B completely enter the concave portion 8, 8 without contacting. For example, all of the length, width, and depth of the concave portion 8, 8 may be larger than the maximum length, maximum width, and maximum depth of the convex portion 4B, 4B. Also, as shown in FIG. 5, the number of the concave portions 8, 8 is not necessarily needed to be two corresponding to the number of the convex portions 4B, 4B accommodated in the concaves 8, 8. For example, as shown in FIG. 6, if the marker 7b on the surface 7a is scribed exactly, one large concave portion 8' may be formed which can completely accommodate the two convex portions 4B, 4B with a margin.

The material of the board 7 is not subject to any special restriction, and may be Si board, glass, various types of ceramics, and the like. The method for forming the concave portion is selected appropriately depending on the material of the board.

For the optical semiconductor module in accordance with the present invention, if the optical semiconductor device 6 is mounted on the board 7 with the epi-side down system and the two elements are positioned by using the marker 7b, the convex portions 4B, 4B of the optical semiconductor device 6 are accommodated in the concave portions 8, 8 without contacting. Therefore, a pressure is not applied to the convex portions 4B, 4B, so that the breakage and property deterioration of the optical semiconductor device are not caused. Thereupon, the function of the obtained optical semiconductor module does not decrease.

### BRIEF DESCRIPTION OF THE DRAWINGS

FIG. 1 is a perspective view showing a state in which SiNx zones are formed on a semiconductor substrate;
FIG. 2 is a perspective view showing a state in which a semiconductor laminated structure is formed on the substrate shown in FIG. 1 by the vapor phase epitaxial growth method;
FIG. 3 is a perspective view showing a state in which the laminated structure shown in FIG. 2 is mesa etched;
FIG. 4 is a partially cutaway perspective view showing a state in which a ridge-shaped waveguide shown in FIG. 3 is embedded in a semiconductor;
FIG. 5 is an exploded perspective view of an optical semiconductor module in accordance with the present invention;
FIG. 6 is a partial perspective view showing another example of a concave portion;
FIG. 7 is a sectional view showing a state in which a mounting pad zone is formed in the manufacturing process of a board;
FIG. 8 is a sectional view showing a state in which a resist layer is formed;
FIG. 9 is a sectional view showing a state in which an oxide film is removed by etching; and
FIG. 10 is a sectional view of the manufactured board in accordance with the present invention.

### BEST MODE OF CARRYING OUT THE INVENTION

First, a laser diode with mode-field converter (MFC-LD) 6 of a structure shown in FIGS. 4 and 5 was manufactured by using the ordinary vapor phase epitaxial growth method.

This device 6 measures 650 µm long, 350 µm wide, and 100 µm thick. An active section C1 has a length of 500 µm,and a mode field converting section C2 has a length of 150 µm. At the boundary between the active section C1 and the mode field converting section C2, two convex portions 4B, 4B each having a length of 50 µm, a width of 20 µm,and a height of 5 µm are formed.

Next, a Si board is selected as a board, and concave portions were formed by accomplishing the process described below.

First, before forming the concave portions, the surface of the MFC-LD 6 to be mounted was observed under an optical microscope or a scanning electron microscope to exactly know the information about the positions, shapes, and numbers (two in this case) of the convex portions, and a photomask for concave portion to be formed was manufactured in advance based on the information.

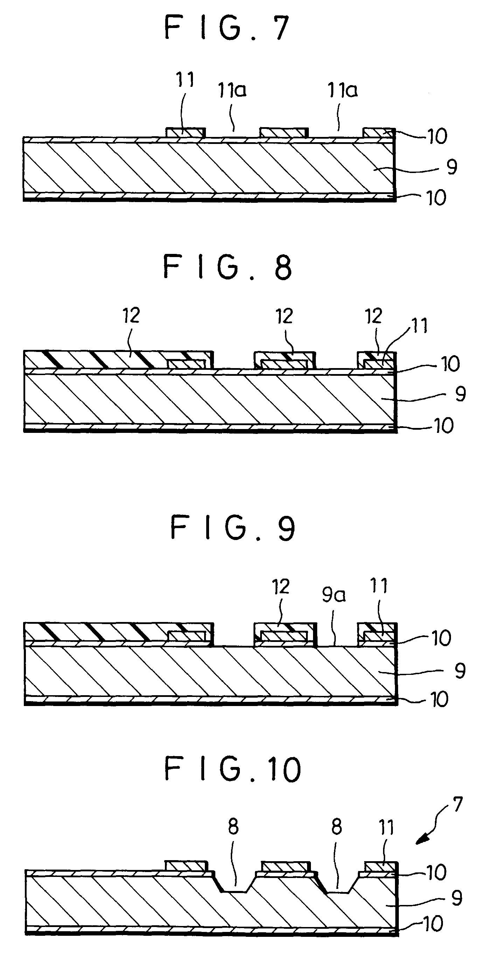

In forming the concave portions, the surface of the Si board 9 was first oxidized to form an oxide film 10, and then a zone 11 consisting of a mounting pad and a wiring pattern was formed by soldering on the oxide film 10 by combining the electron beam depositing method and photolithography (FIG. 7).

This zone 11 has the same shape as that of the optical semiconductor device 6 the whole planar shape of which is mounted, and the edge of the zone 11 matches with a marker 7b shown in FIG. 5. At predetermined locations of the zone 11, holes 11a having a shape, for example, about 10 µm larger than the shape of the concave portion to be formed are formed.

Then, after the aforesaid photomask for concave portion was set on the zone 11, a resist layer 12 for covering the zone 11 was formed over the board 9 except the locations corresponding to the concave portions to be formed by application of resist and photolithography (FIG. 8).

Subsequently, the portions of the oxide film 10 exposed from the resist layer 12 was locally removed by dry etching to expose a surface 9a of the Si board 9 (FIG. 9).

After the resist layer 12 on the surface was completely removed by dry etching under an oxidizing atmosphere, the whole structure was dipped in KOH solution with a temperature of 80°C and a concentration of 10% by weight to wet etch the exposed surface 9a of the Si substrate 9. Since the etching rate of the aforesaid KOH solution was about 1 µm/min, the whole structure was dipped for 10 minutes.

As a result, two concave portions 8, 8 were formed in the aforesaid zone 11 (FIG. 10). The concave portion measured 100 µm long, 50 µm wide, and 10 µm deep. That is, the concave portion has a size large enough to accommodate the concave portion 4B, 4B of the MFC-LD 6 without contacting.

The MFC-LD 6 was lapped on the zone 11 formed on the board 7 thus manufactured and the whole structure was heated, by which the MFC-LD 6 and the board 7 are joined by soldering to make a module.

The convex portions 4B, 4B of the MFC-LD 6 were completely accommodated in the concave portions 8, 8 of the board 7.

Although the formation of concave portion has been explained regarding one Si board in the above embodiment, the formation of concave portion is not limited to this embodiment, and the concave portion can be formed collectively on a wafer before Si boards are cut out. For example, if the size of one optical semiconductor device to be mounted is 5 mm square, about 300 boards can be manufactured collectively using a Si wafer with a diameter of 4 inches (101.6 mm) by a similar procedure. Thereby, the working time and cost for the concave portions can be decreased significantly.

For example, if glass is selected as the material for the board, desired concave portions can be formed by dry etching in a C₂F₆ atmosphere with amorphous Si used as a mask or wet etching using fluorine.

### INDUSTRIAL APPLICABILITY

For the optical semiconductor module in accordance with the present invention, an optical semiconductor device formed with convex portions on the surface thereof is mounted on a board with the epi-side down system, and the board is formed with concave portions of a size and shape such as to accommodate the convex portions of the optical semiconductor device without contacting. Therefore, even if a pressure is applied to the convex portion, the breakage and property deterioration of optical semiconductor device are not caused.

## Claims

1. An optical semiconductor module comprising an optical semiconductor device with convex portions on the surface, arising out of crystal growth, and a mounting board with counterpart concave portions to receive said convex portions, said optical semiconductor device is mounted in said board, where said convex portions are shrouded in said concave portions.
